# EUROPEAN PATENT APPLICATION

(11) **EP 1 035 594 A2**
(43) Date of publication of application: **13.09.2000**
(21) Application number: 00301793.6
(22) Date of filing: 06.03.2000
(51) Int. Cl.: H01L 41/09

(54) **Displacement control device and actuator**

(30) Priority: 05.03.1999 JP 5950599
(71) Applicant: NGK INSULATORS, LTD., Nagoya-City, Aichi Prefecture 467-8530 (JP)
(72) Inventor: Takeuchi, Yukihisa, Nishikamo-gun, Aichi-prefecture 470-0204 (JP); Kimura, Koji, Nagoya City, Aichi-prefecture, 457-0022 (JP)
(74) Representative: Paget, Hugh Charles Edward

(57) **Abstract**

A displacement control device includes: a substrate; two diaphragms joined to at least side surfaces of a recess section made in the substrate; and a connecting plate sandwiched between the two diaphragms and joined to a bottom surface of the recess section. At least one end portion of each of the two diaphragms is joined to the connecting plate and an opposite end portion thereof is joined to the substrate. At least two piezoelectric/electrostrictive elements independent of each other are located at both the diaphragms in a state distributed thereto, and the connecting plate is driven to describe a hysteresis-like displacement locus. The displacement control device is properly applicable to a mechanism for adjusting displacement, position or angle of various kinds of precision parts such as optical units a rotating motor, a linear conveying apparatus, and others.

## Description

### BACKGROUND OF THE INVENTION

### 1. Field of the Invention

The present invention relates to a displacement control device which uses a piezoelectric/electrostrictive element to operate so that its portion describes a hysteresis-like displacement locus, and further relates to an actuator, using the same device, applicable properly to mechanisms for adjusting displacement, position and angle of various types of precision parts and others of optical equipment, precision equipment and other apparatus, and further employable for rotating motors, linear conveying apparatus, or the like.

### 2. Description of the Related Art

In recent years, in the fields of optics, magnetic recording, precision processing and others, a request for a displacement device or an actuator, capable of adjusting an optical path length or a position on the order of submicron, has come into existence. Additionally, of micromachines which have lately been in active study and development on the basis of a fine machining technique, power parts such as motors have become the center of wide interest as equipment parts available in the medical field for local operation or the like.

Moreover, in various types of electronic equipment which have advanced rapidly in size and weight reduction, the parts to be used have been miniaturized naturally, and conveying machines, parts feeders and others to be used for conveyance or selection of such parts also have been required to be suitable for the configurations of the parts and to accomplish high-accuracy drive.

So far, as the foregoing actuator or the like, an electromagnetic motor has come into widespread use. However, the control based upon the electromagnetic motor does not reach very high accuracy. For this reason, if employed for a displacement control apparatus, in many cases, the electromagnetic motor takes charge of rough movement, whereas final fine movement (positioning) relies upon the use of a device equipped with another displacement mechanism. What's more, the electromagnetic motor creates a problem in large power consumption.

As a new technology related to the electromagnetic motor, for example, there has been known an electrostatic type microactuator produced according to an Si or Ni micromachine process in Preliminary Reports "1997 International Conference on solid-state Sensors and Actuators" p1081-1084 of "TRANSDUCER'97". This can offer micro-displacement by applying a voltage to among a plurality of plate-like electrodes formed through the use of a micromachining technique.

There is a problem which arises with this actuator, however, in that difficulty is experienced in increasing the proper frequency because of its structure, so that the vibration is originally hard to attenuate at a high-speed operation, which creates a problem in the manufacturing cost from the micromachining process itself. Accordingly, also with respect to a displacement control apparatus using such an actuator, further improvement is advisable in drive accuracy and in cost.

### SUMMARY OF THE INVENTION

Accordingly, the present invention has been developed in consideration of the foregoing problems concerned with various types of actuators, and it is an object of the invention to provide a displacement control device capable of operating precisely at a high speed but at a low power, and further to provide an actuator using a plurality of displacement control devices each identical to the displacement control device.

For this purpose, in accordance with this invention, there is provided a displacement control device comprising:
a substrate;
two diaphragms joined to at least side surfaces of a recess section made in the substrate; and
a connecting plate sandwiched between said two diaphragms and joined to a bottom surface of the recess section, so that at least one end portion of each of the two diaphragms joined to the connecting plate and an opposite end portion thereof joined to the substrate,
   wherein at least two piezoelectric/electrostrictive elements independent of each other are located at both said diaphragms in a state distributed thereto, and said connecting plate is driven to describe a hysteresis-like displacement locus.

In this case, it is preferable that this displacement control device has a construction in which a fixing plate is joined to one end of the connecting plate.

In addition, in accordance with this invention, there is provided a displacement control device comprising:
a substrate;
two diaphragms joined to at least side surfaces of recess sections made in the substrate, said recess sections being in opposed relation to each other;
a connecting plate whose one end portion in a lengthwise direction, sandwiched between at least said two diaphragms, and whose other end portion in the lengthwise direction being sandwiched between at least two different diaphragms, the connecting plate being placed to span between bottom surfaces of said recess sections, so that at least one end portion of each of said four diaphragms joined to the connecting plate and an opposite end portion thereof joined to the substrate; and
a fixing plate, a lengthwise direction of the fixing plate being in parallel with a direction in which said connecting plate is sandwiched between said diaphragms,
   wherein at least two piezoelectric/electrostrictive elements independent of each other are located at least said two diaphragms which exist at said one end portion of the connecting plate and between which said connecting plate is sandwiched, and said fixing plate is driven to describe a hysteresis-like displacement locus.

In the displacement control device where the fixing plate is used as an indispensable component, it is preferable that a notch portion is made in a joined portion between the fixing plate and the connecting plate. Additionally, it is also preferable that the connecting plate is divided into at least two sections in the lengthwise direction of the fixing plate and the fixing plate is joined to the at-least-two connecting plate sections. Furthermore, it is also acceptable that a hinge section is set on the fixing plate to extend along the lengthwise direction of the fixing plate from the junction between the fixing plate and the connecting plate.

In the above-described all displacement control devices, it is preferable that, at least, the connecting plate and the diaphragms are formed to be joined to each other at their side surfaces, and that, at least, the connecting plate, the diaphragms and the substrate are integrated with each other. Naturally, in the case of the installation of the fixing plate, the fixing plate can also be integrated therewith. Such an integrated construction is producible through the use of a green sheet laminating technique.

In the displacement control device according to this invention, in addition to the piezoelectric/electrostrictive elements for driving, one or more piezoelectric/electrostrictive elements to be employed as auxiliary elements are provided desirably. This case does not require that the driving piezoelectric/electrostrictive elements are identical in type to the auxiliary elements. Additionally, if the piezoelectric/electrostrictive elements and electrode leads conducting to electrodes of the piezoelectric/electrostrictive elements are coated with an insulating layer made of a resin or a glass, the durability is desirably improvable. In this case, preferably, the resin is a fluorocarbon polymer or a silicone resin. Moreover, preferably, a shield layer made of an electrically conductive material is formed on the surface of the insulating layer, which contributes to the improvement and stability of the drive characteristics.

As a suitable material for the substrate, the connecting plate and the diaphragms, there is a fully stabilized zirconia or a partially stabilized zirconia. Additionally, preferably, the configuration of any one of the fixing plate, the connecting plate and the diaphragms is trimmed by the laser beam machining or mechanical machining for dimensional adjustment. Still additionally, preferably, the electrodes in the piezoelectric elements are processed by laser beam machining or mechanical machining for the adjustment of the available electrode area of the piezoelectric elements.

Moreover, this invention provides an actuator using the foregoing displacement control device. That is, there is provided an actuator using a plurality of displacement control devices each driven through the drive of two or more independent piezoelectric/electrostrictive elements so that a connecting plate or a fixing plate describes a hysteresis-like displacement locus, wherein the fixing plates are disposed so that their center lines run substantially parallel with each other, and/or the connecting plates are disposed so that their center lines run parallel with each other.

Still moreover, in accordance with this invention, there is provided an actuator using a plurality of displacement control devices each driven through the drive of two or more independent piezoelectric/electrostrictive elements so that a connecting plate or a fixing plate describes a hysteresis-like displacement locus, wherein the displacement control devices are located at its circumferential section.

In these cases, preferably, the plurality of displacement control devices are disposed so that the center lines of the fixing plates or the connecting plates intersect with each other and tip portions of the fixing plates or the connecting plates are directed to the intersection of the center lines of the fixing plates or the connecting plates.

### BRIEF DESCRIPTION OF THE DRAWINGS

Other object and features of the present invention will become more readily apparent from the following detailed description of the preferred embodiments taken in conjunction with the accompanying drawings in which:
Fig. 1A is a plan view showing an embodiment of a displacement control device according to this invention;
Fig. 1B is a cross-sectional view showing the same as shown in Fig. 1A;
Fig. 2 is a perspective view showing an embodiment of a piezoelectric element to be set in a displacement control device according to this invention;
Fig. 3 is a perspective view showing another embodiment of the piezoelectric element to be set in a displacement control device according to this invention;
Fig. 4 is a perspective view showing a further embodiment of the piezoelectric element to be set in a displacement control device according to this invention;
Figs. 5A to 5D are illustrations useful for describing a drive mode of the displacement control device according to this invention;
Fig. 6 is an illustrative view showing the transmission of a force to another object due to the drive of a displacement control device according to this invention;
Fig. 7A is a plan view showing another embodiment of a displacement control device according to this invention;
Fig. 7B is a cross-sectional view showing the same as shown in Fig. 7A;
Fig. 8 is a plan view showing a further embodiment of a displacement control device according to this invention;
Fig. 9A is a plan view showing a further embodiment of a displacement control device according to this invention;
Fig. 9B is a cross-sectional view showing the same as shown in Fig. 9A;
Fig. 10 is a plan view showing a further embodiment of a displacement control device according to this invention;
Fig. 11 is a plan view showing a further embodiment of a displacement control device according to this invention;
Fig. 12A is a plan view showing a protection mode of electrodes and others of a displacement control device according to this invention;
Figs. 12B to 12D are cross-sectional views showing the same as shown in Fig. 12A;
Fig. 13 is a plan view showing an example of configuration of a sheet member for use in manufacturing a displacement control device according to this invention;
Fig. 14 is an illustration useful for explaining one example of a piezoelectric element processing method for a displacement control device according to this invention;
Fig. 15 is a plan view showing an embodiment of an actuator using a displacement control device according to this invention;
Fig. 16A is a perspective view showing another embodiment of an actuator using a displacement control device according to this invention;
Fig. 16B is a cross-sectional view showing the same as shown in Fig. 16A;
Fig. 17A is a plan view showing a further embodiment of an actuator using a displacement control device according to this invention;
Fig. 17B is a cross-sectional view showing the same as shown in Fig. 17A;
Fig. 18A is a plan view showing a further embodiment of an actuator using a displacement control device according to this invention;
Fig. 18B is a cross-sectional view showing the same as shown in Fig. 18A.

### DESCRIPTION OF THE PREFERRED EMBODIMENTS

Referring to the drawings, a description will be made hereinbelow of a displacement control device (which will hereinafter be referred to simply as a device) according to the present invention, and of an actuator using this device. As will be obvious from the following description, the device according to this invention is made such that a connecting plate or a fixing plate constituting its component moves to describe a hysteresis-like displacement locus owing to the drive of piezoelectric/electrostrictive elements, while the meaning of the term "hysteresis-like" will be mentioned herein later. Additionally, an actuator according to this invention signifies a group of devices including a plurality of displacement control devices as components, and the sense of the actuator is not always limited to that the actuator works on another object, but including a case in which the actuator per se moves or rotates.

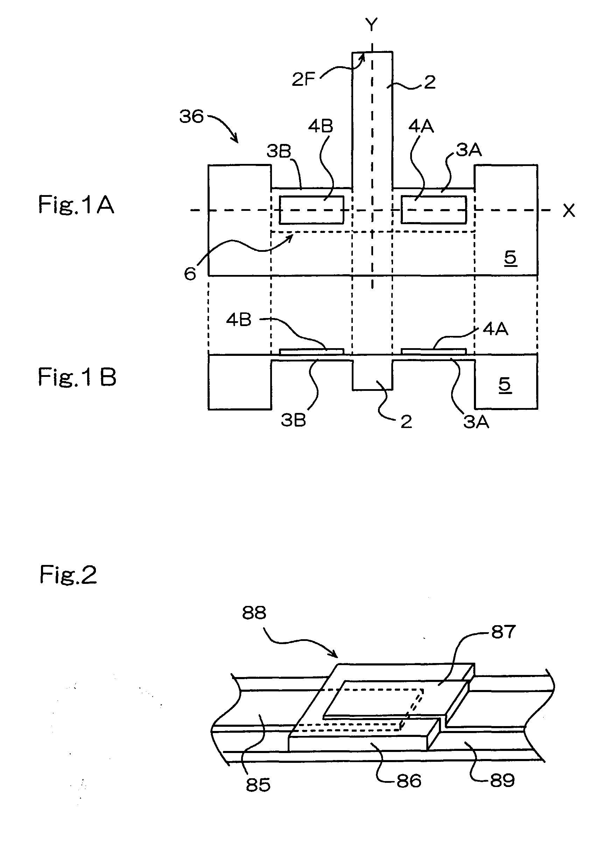

Fig. 1A is a plan view showing a device 36, while Fig. 1B is a cross-sectional view showing a cross section including X axis and perpendicular to the plan view (paper surface) (which will be referred to hereinafter as a cross-sectional view taken along an X axis).

The device 36 has a structure in which a connecting plate 2 is interposed between two diaphragms 3A and 3B (this interposing direction, that is, the direction of joining the connecting plate with the diaphragms 3A and 3B, is referred to as an "X-axis direction", and so forth), and the connecting plate 2 is joined onto a bottom surface of a recess portion made in a substrate 5 while the diaphragms 3A and 3B are joined onto the side surface and bottom surface of the recess portion 6. In this case, preferably, the joining direction of the connecting plate 2 and the substrate 5 is perpendicular to the X axis, and will be referred to hereinafter as a "Y-axis direction"). Additionally, piezoelectric/electrostrictive elements 4A and 4B (which will be referred to hereinafter as "piezoelectric elements") independent of each other are placed on one main surfaces of the diaphragms 3A and 3B, respectively.

In the device 36, it is necessary to join the diaphragms 3A and 3B to at least the side surfaces of the recess portion 6, whereas they are not always required to be joined to the bottom surface of the recess portion 6. That is, it is also possible that the diaphragms 3A and 3B are located between the connecting plate 2 and the side surfaces of the recess portion 6.

In the piezoelectric elements 4A and 4B, although electrode leads from electrodes constituting the piezoelectric elements 4A and 4B are disposed toward the substrate 5, they are omitted from the drawings of Figs. 1A and 1B. Incidentally, the term "independent piezoelectric elements" signifies that the piezoelectric elements themselves are of a separate type and further that the piezoelectric elements can individually be driven independently of each other.

The joining of the connecting plate 2, the diaphragms 3 and the substrate 5 is made appropriately at their side surfaces, and preferably, they are integrated with each other. The use of the green sheet laminating method easily enables the integrated structure of the device 36. Although the connecting plate 2 is formed to have larger thickness than the thickness of the diaphragms 3, it is also acceptable to have a thickness substantially equal to that of the diaphragms 3.

In this case, the connecting plate means an element which propagates displacement or vibrations of an diaphragm arising with the drive of a piezoelectric element and enlarges or enhances the displacement of the diaphragm. A fixing plate can be joined to the tip portion of the connecting plate so that the configuration of the tip portion is taken optionally. That is, the connecting plate also fulfills a function to make a connection between the fixing plate and the substrate for displacing or vibrating the fixing plate or the like. In the device 36, it can be thought that the connecting plate 2 itself also functions as a fixing plate.

The diaphragm is an element which converts a strain of a piezoelectric element located on a main plane (surface) into a displacement or vibrations in a bending mode to transfer this displacement or vibrations to the connecting plate. Additionally, the diaphragm conversely has a function to propagate, to the piezoelectric element, the deformation occurring at the displacement or vibrations of the connecting plate, the fixing plate joined to the connecting plate, or the like. The substrate means an element which is for holding a moving portion (such as the connecting plate, the diaphragms, the piezoelectric elements, the fixing plate (if provided), and other components). Additionally, it has various types of electrode terminals for attachment to a drive apparatus or a measuring apparatus, and is used for handling in the actual use.

As mentioned above, the substrate 5 has the recess portion 6 made to hold the connecting plate 2 and the diaphragms 3A and 3B in the predetermined form shown in Figs. 1A and 1B, and the side surface(s) (a surface(s) perpendicular to the X axis) and the bottom surface (a surface perpendicular to the Y axis) of the recess portion 6 are not always required to be perpendicular to each other, and the intersection between the side surface and the bottom surface can have a curvature. It is also possible to make such a recess portion 6 by notching a portion of the outer circumferential side surface of the substrate 5, or to, when a rectangular hole section is made in the interior of the substrate 5, use three side surfaces of the four side surfaces.

Accordingly, while the recess portion 6 is not always required to be open in one of the Y-axis directions that the connecting plate 2 protrudes, in this case, as mentioned later, the configuration of the recess portion 6 is required to be set so as not to exert adverse influence on the displacement locus of the connecting plate 2 for use in the device 36.

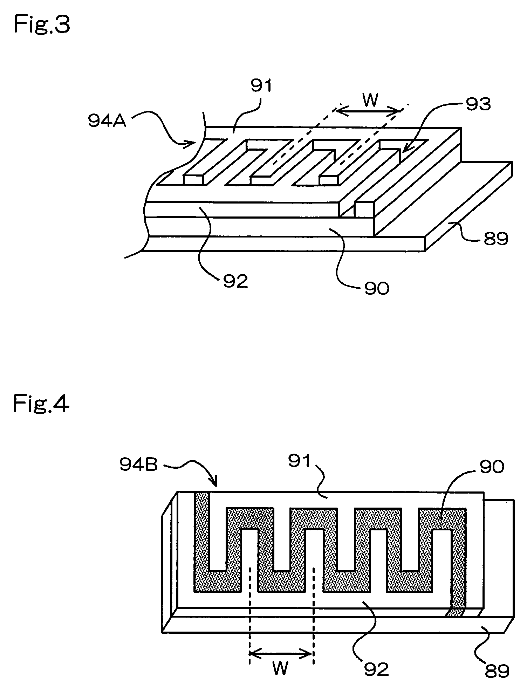

As the piezoelectric elements 4A and 4B, as shown in Fig. 2, a typical element is a piezoelectric element 88 formed in a laminating form in a manner that a piezoelectric film 86 is placed on an diaphragm 89 in a state interposed between a first electrode 85 and a second electrode 87, and it is also appropriate to use a piezoelectric element 94A having a comb-like configuration in which, as shown in Fig. 3, a piezoelectric film 90 is provided on an diaphragm 89, and a first electrode 91 and a second electrode 92 are formed on the piezoelectric film 90 to define a gap portion 93, having a constant width, therebetween. Incidentally, in Fig. 3, the first electrode 91 and the second electrode 92 can also be formed between the diaphragm 89 and the piezoelectric film 90. Additionally, it is also appropriate to use a piezoelectric element 94B in which, as shown in Fig. 4, a piezoelectric film 90 is embedded between a first electrode 91 and a second electrode 92 having a comb-like configuration. In the case of the piezoelectric element 88, the transverse effect (d₃₁) of the electric field induced strain is taken properly, while in the piezoelectric elements 94A and 94B, the longitudinal effect (d₃₃) of the electric field induced strain is available appropriately.

In the case of using the piezoelectric elements 94A and 94B having the electrodes having the comb-like configuration as shown in Figs. 3 and 4, if the pitch W of the comb-like electrode configuration is shortened, it is possible to increase the quantity of strain thereof. Such piezoelectric elements, shown in Figs. 2 to 4, are applicable to all devices according to this invention which will be described herein later. Thus, when a voltage is applied to the piezoelectric elements 4A and 4B, such as the piezoelectric element 88 and others, which can accept various types, a strain corresponding to the applied voltage occurs in the piezoelectric film, and this strain propagates to the diaphragms 3 and then arrives at the connecting plate 2 so that the connecting plate 2 displaces in a predetermined amount.

Assuming that a piezoelectric element of a type using d₃₁ is provided as the piezoelectric elements 4A and 4B of the device 36, consideration is given to a process in which the connecting plate 2 is displaced due to the strain occurring in the piezoelectric elements 4A and 4B. Voltages to be applied to the piezoelectric elements 4A and 4B are taken as VA and VB, respectively, and the axis orthogonally crossed to both the X and Y axes is referred to as a Z axis.

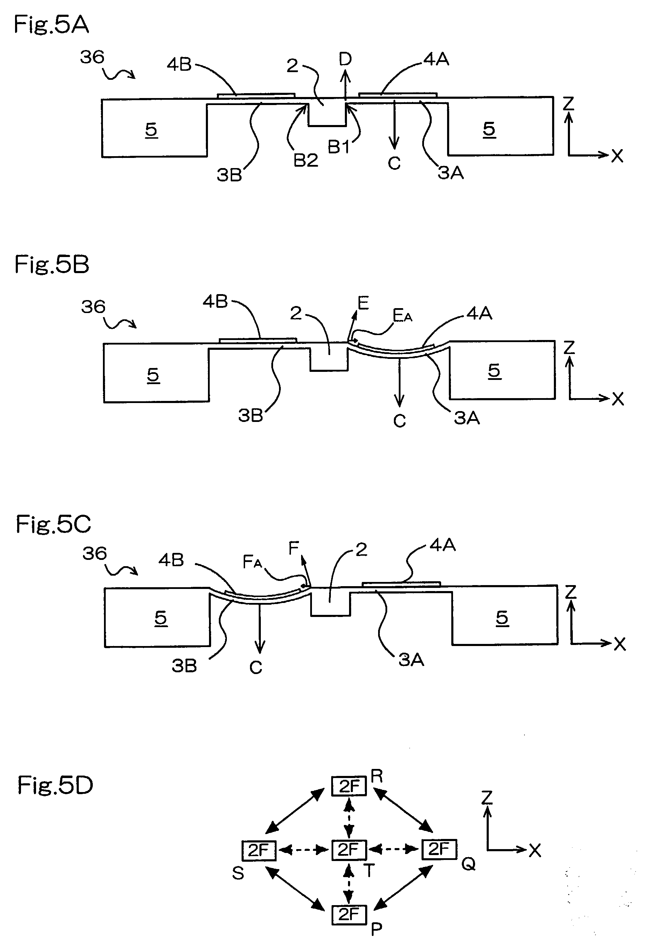

Figs. 5A to 5C are cross-sectional views in a Z-X plane, corresponding to Fig. 1B, and are drawings useful for explaining the transition of the displacement of the connecting plate 2, while Fig. 5D is an illustration available for describing the variation of the position of a tip surface 2F of the connecting plate 2 on the same Z-X plane. First, if the piezoelectric element 4B is not driven while a voltage is applied to only the piezoelectric element 4A, an electric field induced strain occurs in the piezoelectric film so that the piezoelectric element 4A contracts in the X-axis direction. Thus, as shown in Fig. 5A, a displacement in a bending mode occurs in the Z-axis direction perpendicular to the main surface of the diaphragm 3A, as indicated by an arrow C. At this time, a force in a direction reverse to the arrow C acts on a joined portion B1 between the diaphragm 3A and the connecting plate 2 in a direction indicated by an arrow D. This arrow D direction corresponds to the Z-axis direction, and since the arrow D direction is perpendicular to the X-axis direction, the force does not contain a component which can displace the connecting plate 2 in the X-axis direction; therefore, at the moment of the voltage application, the connecting plate 2 is not displaced in the X-axis direction.

However, when a bending occurs in the diaphragm 3A, the direction of the force acting on the joined portion B1 turns from the arrow D direction to a direction indicated by an arrow E as shown in Fig. 5B so that an X-axis component (arrow E_{A}) develops. Thus, it is considered that the connecting plate 2 is displaced in the X-axis direction (the right direction in the illustration). On the other hand, the three sides of the diaphragm 3A are joined to the substrate 5 and the connecting plate 2, but one side thereof forms a free end. Accordingly, as the bending displacement of the diaphragm 3A increases, the free end of the diaphragm 3A displaces in the arrow D direction, namely in the Z-axis direction (upward direction in the illustration), and this displacement of the diaphragm 3A in the Z-axis direction causes the connecting plate 2 to displace in the Z-axis direction.

That is to say, when the position of the tip surface 2F of the connecting plate 2 in a state where no driving voltage is applied to the piezoelectric elements 4A and 4B is taken as P in Fig. 5D, with the drive of only the piezoelectric element 4A, the tip surface 2F of the connecting plate 2 displaces to shift from the P point to a Q point. Accordingly, at the Q point, the voltage applied to the piezoelectric element 4A is at VA while the voltage applied to the piezoelectric element 4B is at zero (0). Such a voltage application condition will be referred to hereinafter as "(VA · 0)".

Contrary to the above description, considering that no voltage is applied to the piezoelectric element 4A but a voltage is applied to only the piezoelectric element 4B, as shown in Fig. 5C, a force indicated by an arrow F, working on a joined portion B2 between the connecting plate 2 and the diaphragm 3B acts in a direction symmetrical with respect to that of the force indicated by an arrow E in Fig. 5B, produced for when only the piezoelectric element 4A is driven. That is, with the drive of only the piezoelectric element 4B, as shown in Fig. 5D, the tip surface 2F of the connecting plate 2 displaces to shift from the P point to the S point. The voltage application state at this S point is expressed as (0 · VB).

Accordingly, when a voltage is applied to the piezoelectric element 4B in a state where the voltage application to the piezoelectric element 4A is maintained from the condition in which the tip surface 2F of the connecting plate 2 is at the Q point, the displacement components in the X-axis directions are offset to decrease; however, since the displacement components in the Z-axis direction are superimposed on (added to) each other, the displacement in the X-axis direction becomes zero in the condition of the predetermined voltage (VA · VB), and the tip surface 2F of the connecting plate 2 becomes movable to the R point where the largest displacement takes place in the Z-axis direction.

In this way, by changing the voltage application condition to the two independent piezoelectric elements 4A and 4B, the connecting plate 2 can be driven so that its tip surface 2F shifts along the route of P point → Q point → R point → S point → P point to describe a hysteresis-like displacement locus, and naturally it can also be driven so that the tip surface 2F takes the route reverse thereto. Additionally, when the voltages to be applied to the piezoelectric elements 4A and 4B are taken as (VA/2 · VB/2), it is possible to displace the connecting plate 2 to a T point. Accordingly, the connecting plate 2 can also be driven to take the route of P point → Q point → T point → S point → P point. In this case, between the Q point and the S point, a driving condition in which the displacement quantity in the Z-axis direction does not change relatively takes place.

In consequence, in the structure in which the connecting plate 2 is interposed between the two diaphragms 3A and 3B, with the drive of at least the two independent piezoelectric elements 4A and 4B, the connecting plate 2 can be driven to draw a hysteresis-like displacement locus along an arbitrary route in the range surrounded by the P, Q, R and S points. Incidentally, in Fig. 5D, although the displacement locus between the P, Q, R, S and T points is shown linearly, naturally, as mentioned above, through the adjustment of the voltage to be applied to each of the piezoelectric elements 4A and 4B, it is possible to describe a curved or substantially circumferential locus.

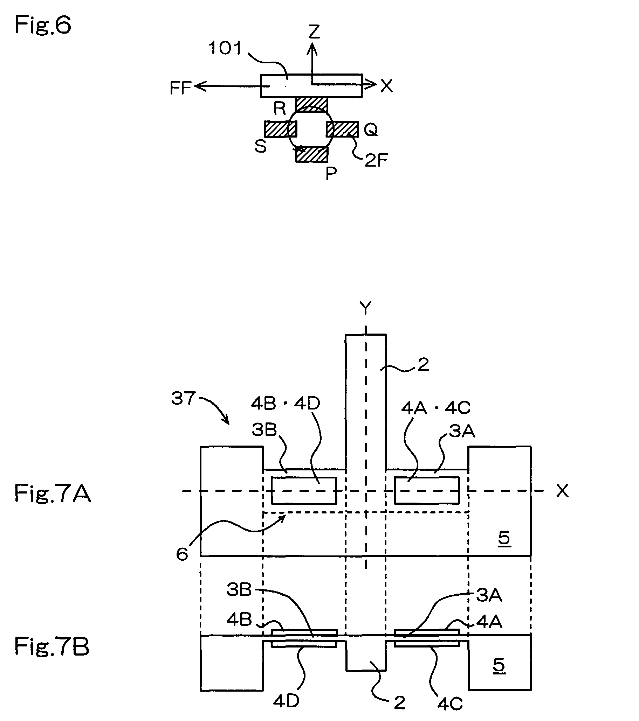

Thus, for example, when, as shown in Fig. 6, an object 101 is put on an X-Y plane of the connecting plate 2 and the tip surface 2F of the connection plate 2 is driven to rotate counterclockwise, the object 101 is movable in the minus direction of the X axis (direction indicated by an arrow FF by at least the friction between the connecting plate 2 and the object 101. In the connecting plate 2, the portion at which the connecting plate 2 comes into contact with the object 101 can take a circular cross section, in place of the rectangular cross section shown in Fig. 6. That is, the shape of the connecting plate 2 is not limited to a rectangular configuration. Although the above description relates to the case in which an element of a type utilizing d₃₁ is employed as the piezoelectric element, also in the case of an element of a type utilizing d₃₃, the connecting plate 2 can likewise be driven to describe a hysteresis-like displacement locus.

Furthermore, in this invention, the term "hysteresis-like displacement locus" used as a displacement mode of the connecting plate 2 is used as the following meaning. In general, the "hysteresis" signifies a phenomenon in which, when, in accordance with variation of one quantity A, another quantity B also varies, the quantity B varies with respect to the same quantity A depending upon the route of the variation of the quantity A, and if the quantity A is replaced by the X-axis displacement position of the connecting plate 2 while the quantity B is replaced with the Z-axis displacement position of the connecting plate 2, when a voltage is applied to the piezoelectric element 4A, for example, in the case in which the voltage is varied in the range of 0 to VA, the relationship between the variation of the X-axis displacement position of the connecting plate 2 and the variation of the Z-axis displacement position thereof is commonly expressed by the route from the P point to the Q point in Fig. 5D. In this case, the Z-axis displacement position of the connecting plate 2 relative to the X-axis displacement position thereof is determined univocally.

On the other hand, in this invention, through the voltage application to the piezoelectric element 4B, the connecting plate 2 can be driven to take the route from the Q point to the R point. Accordingly, with respect to the X-axis displacement position of the same connecting plate 2, the Z-axis displacement position assumes different position, and the Z-axis displacement position relative to the X-axis displacement position is not determined univocally. The displacement route of the Q point → R point → S point → P point is one example of displacement route (locus) of this device, and in this invention, the term "hysteresis-like displacement locus" is used as such a displacement mode. Accordingly, in the reciprocating displacement (Z-axis direction oscillation) between the P point and the R point, the Z-axis displacement position of the connecting plate 2 assumes a plurality of values (multivalue) with respect to the X-axis displacement position thereof. This can also be included in the hysteresis-like displacement locus.

The voltage to be actually applied to the piezoelectric elements for driving the device according to this invention to describe the foregoing hysteresis-like displacement locus is required to be adjusted appropriately on the basis of the structure of the piezoelectric elements, the piezoelectric characteristic of the piezoelectric films, the difference in dimension between the piezoelectric elements in one device, and other factors for drawing a proper hysteresis-like displacement locus.

In the above-described device 36, since the connecting plate 2 is interposed between a plurality of diaphragms, the twisted displacement around the Y axis is restrainable. Additionally, in this case, the displacement in the Z-axis direction is suppressible, while the displacement quantity in the X-axis direction increases. Still additionally, in the case in which the diaphragms 3A and 3B are not joined to the bottom surface of the recess portion, the twisted displacement around the Y axis tends to occur, while a large displacement quantity in the Z-axis direction is possible. Moreover, as will be mentioned herein later, the configuration of the connecting plate 2 can also control the configuration of the hysteresis-like displacement locus. Thus, the configuration of the hysteresis-like displacement locus can be changed according to the method of controlling the voltage to be applied to the piezoelectric elements, while it can also be changed by the structural design of the device itself.

Secondly, a description will be given hereinbelow of devices according to further embodiments, which can be driven to describe a hysteresis-like displacement locus as mentioned above as well as the aforesaid device 36. A device 37, shown in a plan view of Fig. 7A and in a cross-sectional view Fig. 7B taken along an X axis in the plan view, employs a mode in which piezoelectric elements (4A, 4C) or (4B, 4D) independent of each other are placed both main surfaces of each of the diaphragms 3A and 3B used in the device 36. In this case, as the piezoelectric elements 4A to 4D, elements of a type using d₃₁ or of a type of d₃₃ are properly selected and provided thereon. The piezoelectric elements 4A to 4D are driven according to the aforesaid drive principle shown in Figs. 5A to 5D; whereupon, the drive becomes feasible through the use of all the piezoelectric elements 4A to 4D. For example, the piezoelectric element 40 utilizing d₃₃ is driven to further increase the displacement of the diaphragm 3A caused by the drive of the piezoelectric element 4A using d₃₁.

On the other hand, as well as the device 36, in the device 37, it is possible that the piezoelectric elements 4A and 4B are used as driving elements while the piezoelectric elements 4C and 4D are used as auxiliary elements. The auxiliary elements signify a fault diagnosing element, a displacement confirming/deciding element, a drive assistant element or the like, and the use of the auxiliary elements enables high-accuracy drive of the connecting plates. it is also preferable to provide a plurality of auxiliary elements different in application from each other.

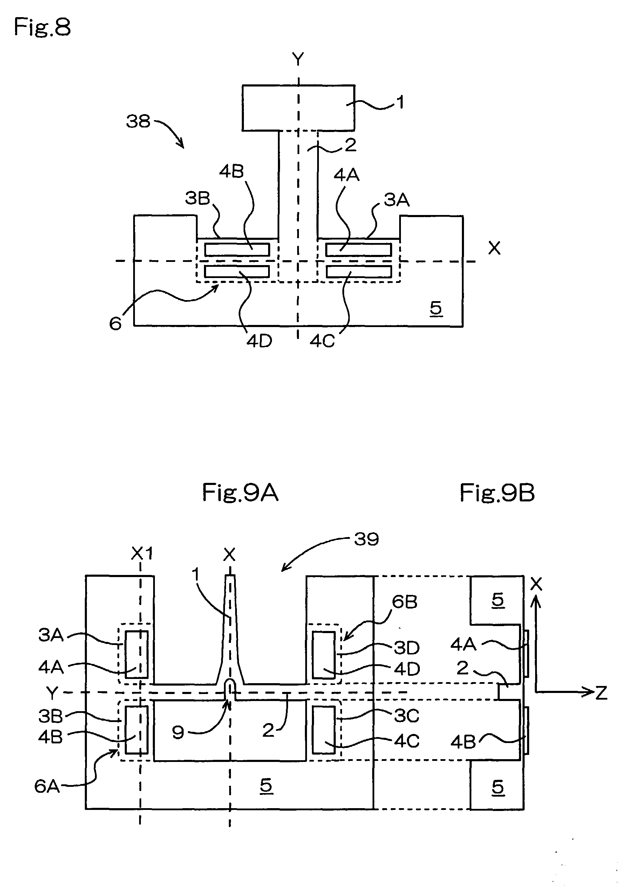

A plan view of Fig. 8 shows a device 38 in which a fixing plate 1 is joined to the tip portion of the connecting plate 2 used in the device 36. In this case, the fixing plate 1 serves as an element for additionally increasing the displacement of the connecting plate 2 to be displaced by a predetermined quantity. For example, in a case in which an object which is hard to bring into contact with a bar-like member such as the connecting plate 2 illustrated is moved, the fixing plate 1 is designed to the configuration or the like of that object.

In the device 38, two independent piezoelectric elements 4A and 4C separated in the Y-axis direction are formed on one main surface of one diaphragm 3A, while similar piezoelectric elements 4B and 4D are also set on the other diaphragm 3B. In this case, preferably, the piezoelectric elements 4A and 4B closer to the fixing plate 1 are used as driving elements while the piezoelectric elements 4C and 4D on the bottom surface side of the recess portion 6 are used as auxiliary elements. The division of the piezoelectric element accepts a method of providing the piezoelectric elements 4A and 4B and then of dividing them by the laser beam machining, which will be described later, or the like, and a method of providing the piezoelectric elements 4A to 4D in the form of a set of two elements in the first place. Such piezoelectric elements division formation and using method are applicable to all the devices according to this invention.

Furthermore, Figs. 9A is a plan view showing a device 39, while Fig. 9B is a cross-sectional view taken along an X1 axis in the plan view. The device 39 has a structure in which a connecting plate 2 whose one end portion in its longitudinal direction (Y-axis direction) is interposed between diaphragms 3A and 3B and whose other end portion is interposed between two different diaphragms 3C and 3D is located to extend between bottom surfaces of recess portion 6A and 6B made in a substrate 5 to be in opposed relation to each other, and the diaphragms 3A to 3D are joined to the bottom surfaces and side surfaces of the recess portion 6A and 6B, and the fixing plate 1 is joined to the connecting plate 2 so that the longitudinal direction of the fixing plate 1 is parallel with the direction (X-axis direction) of the interposition of the connecting plate 2 by the diaphragms 3A, 3B, 3C and 3D.

Furthermore, while piezoelectric elements 4A to 4D independent of each other are provided on main surfaces of the diaphragms 3A to 3D, respectively, as well as the aforesaid device 37, it is also possible that the piezoelectric elements are located on both the main surfaces of the diaphragms 3A to 3D. Additionally, as obvious from a drive mode of the device 39 which will be described later, it is also possible that the piezoelectric elements 4A and 4B are provided on only the diaphragms 3A and 3B which interpose one end portion of the connecting plate 2 therebetween. However, as compared with the mode in which four independent piezoelectric elements 4A to 4D for driving are respectively provided on the diaphragms 3A to 3D, in the case of being driven by these two independent piezoelectric elements, this device is inferior in the displacement enlargement efficiency.

Incidentally, it is also appropriate that, in place of the diaphragm 3A, two diaphragms whose flat surfaces are facing each other are used as one set and, instead of the diaphragm 3B, two diaphragms are similarly used as one set, that is, diaphragms which are four in number in total accept the connecting plate therebetween. This also apply to the diaphragms 3C and 3D.

The location of the piezoelectric elements 4A and 4B and the piezoelectric elements 4C and 4D in the device 39 is similar to that of the piezoelectric elements 4A and 4B in the aforesaid device 36, and preferably, in the device 39, all the piezoelectric elements 4A to 4D are made with an element of a type using d₃₁ or d₃₃.

For example, if a piezoelectric element of a type using d₃₁ is used as the piezoelectric elements 4A to 4D, first, a voltage is applied to the piezoelectric elements 4A and 4C, since the force by which the piezoelectric element 4A displaces the connecting plate 2 in the X-axis direction and the force by which the piezoelectric element 4C displaces the connecting plate 2 in the X-axis direction are reverse to each other, at the joined portion between the fixing plate 1 and the connecting plate 2, a force occurs which rotates the connecting plate 2 around the vicinity of the intersection of the X axis and the Y axis in the X-Y plane. This force causes the fixing plate 1 to shift so that the tip portion of the fixing plate 1 is driven in the Y-axis direction centering around the vicinity of the intersection between the X axis and the Y axis.

That is to say, the device 39 has a two-step displacement enlarging mechanism whereby the bending displacement of the piezoelectric elements 4A and 4C causes the deflection displacement of the connecting plate 2 in the X-axis direction, and the deflection displacement of the connecting plate 2 is converted into the rotational displacement of the fixing plate 1 in the Y-axis direction. At this time, the enlargement of the displacement is achievable by the design on the length of the fixing plate 1 in the X-axis direction, or the like. Additionally, the displacement of the connecting plate 2 arising in the Z-axis direction is also transmitted to the fixing plate 1.

Likewise, when a voltage is applied to the piezoelectric elements 4B and 4D, as compared with the drive of the piezoelectric elements 4A and 4C, although similarly in the Y-axis directions, the displacement occurs in the reverse direction.

In this way, as well as the piezoelectric elements 4A and 4B in the aforesaid device 36, the piezoelectric elements 4A and 4B in the device 39 are driven so that the connecting plate 2 describes a hysteresis-like displacement locus, and the voltage application condition is set to a set of piezoelectric elements 4A and 4C, and at the same time the voltage application condition is set to a set of piezoelectric elements 4B and 4D; whereupon, when the movement of the tip surface of the fixing plate 1 is expressed on the Y-Z plane, the fixing plate 1 can be driven to describe a hysteresis-like displacement locus similar to that shown in Fig. 5D.

A notch portion 9 made in the joined portion between the connecting plate 2 and the fixing plate 1 in the device 39 plays a role of effectively developing the aforesaid enlargement conversion of the X-axis direction displacement of the connecting plate 2 into the Y-axis direction displacement of the fixing plate 1, and preferably, the notch portion 9 is made lengthily such that its length in the cross direction of the connecting plate 2, that is, the length in the X-axis direction, reaches the interior of the fixing plate 1. On the other hand, it is preferable to shorten the width of a notch portion 11, that is, the length of the notch portion 9 in the Y-axis direction.

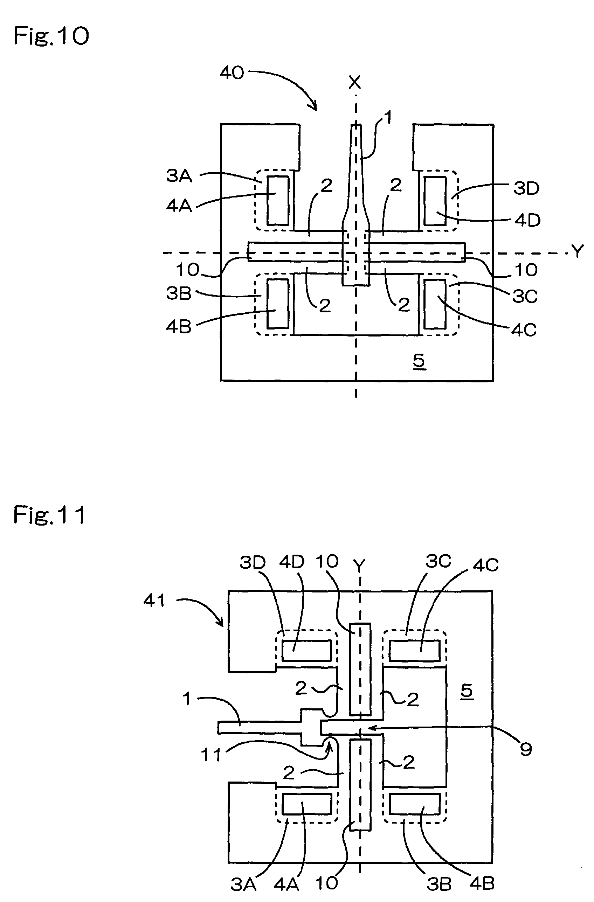

Furthermore, a device 40 shown in Fig. 10 has a structure in which a connecting plate 2 is divided into two along a longitudinal direction of a fixing plate 1 (X-axis direction) and each of the divided connecting plates 2 is further divided into two along an spanning direction of the connecting plate 2 (Y-axis direction). Thus, as a result, the fixing plate 1 is joined to one side of main surfaces of four connecting plates 2 to be located transversely throughout the four connecting plates 2. In this case, naturally, the connecting plates 2 and the fixing plate 1 are joined integrally with each other. Additionally, it is also acceptable that the connecting plate 2 is divided into three or more sections. In this invention, the division of the connecting plate in the longitudinal direction (X-axis direction) of the fixing plate also includes, for example, the case in which the division of the connecting plate consequently creates a gap between the divided sections so that the width of the connecting plate of the divided sections in the X-axis direction decreases and the case in which a plurality of connecting plates are arranged in a row with each other in a state where a gap is interposed therebetween in the X-axis direction but in a state where the X-axis direction width of the connecting plates does not change.

Since the device 40 employs a mode in which each of the piezoelectric elements 4A to 4D drives the corresponding connecting plate 2 through the corresponding one of the diaphragms 3A to 3D, a plurality of points at which the deformation of the piezoelectric elements 4A to 4D act on the fixing plate 1 are given so that the fixing plate 1 can effectively be driven in the same driving manner as that for the device 39.

Incidentally, in a gap portion 10 between the connecting plates 2, it is also acceptable that a plate-like member whose thickness is smaller than that of the connecting plates 2 is located to span between the connecting plates 2 in the X-axis direction. In this case, as compared with the case of no location of the plate-like member, although the relative displacement of the fixing plate 1 decreases, the rigidity increases so that the fixing plate 1 is movable at a higher response speed. Additionally, the gap portion 10 is not always required to be formed throughout the overall length (the length in the Y-axis direction) of the connecting plate 2. Even if covering a partial range, the effects are attainable.

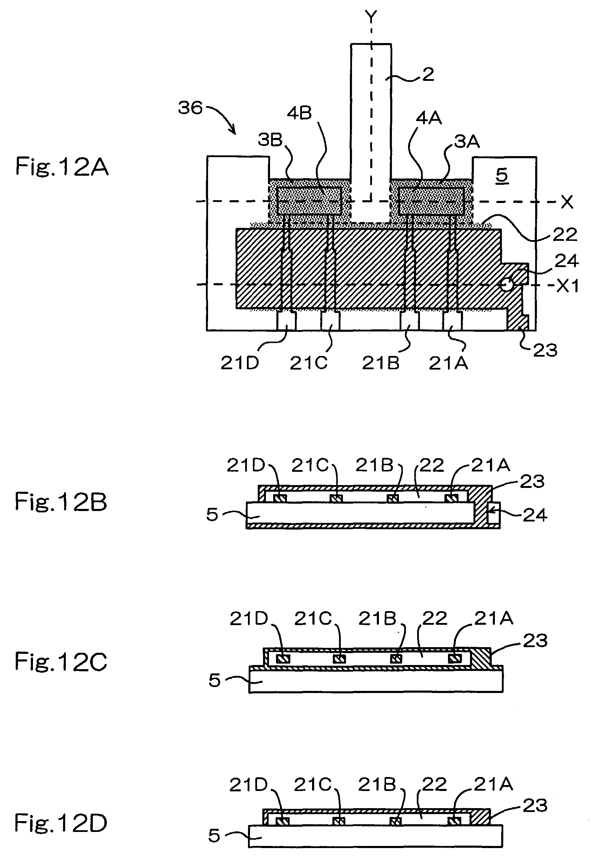

Fig. 11 is a plan view showing a device 41 in which not only a fixing plate 1 is joined integrally to two divided connecting plates 2 in the longitudinal direction of the fixing plate 1 but also a hinge portion 11 is made in the fixing plate 1 along the longitudinal direction of the fixing plate 1 from the joined portion between the fixing plate 1 and the connecting plate 2 and even a notch portion 9 is made in the joined portion between the fixing plate 1 and the connecting plates 2. The hinge portion 11 assists the displacement drive of the tip portion of the fixing plate 1 in the Y-axis direction, and owing to the additional formation of the notch portion 9, a large displacement is obtainable more effectively. Such a hinge portion 11 can also be made in the foregoing devices 39 and 40.

Still furthermore, a description will be given hereinbelow of the formation of electrode leads from piezoelectric elements, for example, in the above-described device 36. Fig. 12A is a plan view showing a mode in which electrode leads 21A to 21D are set to piezoelectric elements 4A and 4B provided in the device 36 and an insulating layer 22 is placed on the piezoelectric elements 4A and 4B and the electrode leads 21A to 21D, and is covered with a shield layer 23. Fig. 12B to 12D are cross-sectional views taken along an X1 axis in Fig. 12A, illustrating different modes.

The insulating layer 22 serves effectively to improve the environment resistance characteristics of the piezoelectric elements 4A and 4B. The shield layer 23 has a function to, for example, when the device is driven at a high frequency, intercept electromagnetic waves from the external to excellently secure the displacement accuracy, and further has a function to prevent malfunction or the introduction of noises.

As modes of the formation of the shield layer 23, the shield layer 23 covers a substrate 5 as shown in Fig. 12B, the shield layer 23 covers only the wiring section on the substrate 5 as shown in Fig. 12C, or the shield layer 23 is placed on only one side, i.e., the upper side, of the wiring section as shown in Fig. 12D. Of these, the shield layer 23 formation modes of shielding the entire wiring section, shown in Figs. 12B and 12C, are desirable. Incidentally, in Fig. 12A, while connection between portions of the shield layer 23 formed on the surfaces of the substrate 5 is made through the use of a through hole 24 made in the substrate 5, it is also possible that this connection is made through a side surface of the substrate 5. A detailed description on the materials for use in the formation of insulating layer 22 and the shield layer 23 will be given at a later description of a material for the devices.

A description will be given hereinbelow of a material for use in forming a device according to this invention. The substrate, the fixing plate, the connecting plate and the diaphragms may be made of an insulating material or a dielectric material capable of being formed integrally with the piezoelectric elements without using an adhesive, a suitable material is ceramics. For example, as oxide, there are listed fully stabilized zirconia, partially stabilized zirconia, alumina, magnesia and others, and as non-oxide, there are listed silicon nitride and others. Of these, the fully stabilized zirconia and the partially stabilized zirconia show a high mechanical strength even in the form of a sheet, and further show a high toughness and a low reactivity with piezoelectric films and electrode materials; accordingly, these material are most suitable therefor. Incidentally, in the case in which the fully stabilized zirconia and the partially stabilized zirconia are employed as the material for these plates, at least for the diaphragms, it is preferable that they contain an additive such as alumina or titania.

Furthermore, in the case of use of ceramics, since the device can be formed integrally according to a green sheet laminating technique which will be described later, it is preferable in view of, for example, securing the reliability of the joining portion and simplifying the manufacturing process.

In the device according to this invention, as mentioned above, while any limitation is not imposed on the thickness and configuration of the fixing plate and they can be designed properly according to its service, the thickness of the substrate can be determined properly in consideration of the operational performance, and the shape thereof is not always required to be a plate-like configuration. On the other hand, it is preferable that the thickness of the diaphragm is approximately 3 to 20 µ m, and that the thickness of the total of the diaphragm and the piezoelectric element is approximately 15 to 60 µm. Furthermore, for the connecting plate, preferably, its thickness is 20 to 600 µm and its width is 30 to 500 µm, and further, the aspect ratio (the width (length in the X-axis direction)/the length in the thickness direction (Z-axis direction)) of the connecting plate is preferably in a range of 0.1 to 15. Particularly, for further controlling the displacement within the X-Y plane, the aspect ratio is preferable to be in a range of 0.1 to 7.

As the piezoelectric film of the piezoelectric elements, a piezoelectric ceramics is preferable, but it is also possible to use a electrostrictive ceramics, a ferroelectric ceramics or an antiferroelectric ceramics. Additionally, a material which requires a polarization treatment and a material which does not require the polarization treatment are both employable. However, for use in a magnetic recording head or the like, since the linearity between the displacement of the fixing plate and the driving voltage or the output voltage is important, a material showing a small hysteresis of the strain is preferable. Accordingly, a material whose coercive electric field is below 10 kV/mm is preferable.

Concretely, among the piezoelectric ceramics, there are lead zirconate, lead titanate, lead magnesium niobate, lead nickel niobate, lead zinc niobate, lead manganese niobate, lead antimony stannate, lead manganese tungstate, lead cobalt niobate, lead magnesium tantalate, barium titanate, and others, and further, there are mixture of some of these components. This invention uses, of these, a material containing, as a main component, a component comprising lead zirconate, lead titanate and lead magnesium niobate, as a suitable material, because this material, for example, not only has a high electromechanical coupling factor and a high piezoelectric constant, but also shows a low reactivity with the plate (ceramic substrate) at the sintering of the piezoelectric film, and even allows it to be formed stably to have a predetermined composition.

In addition, as the aforesaid piezoelectric ceramics, it is also possible to use a ceramics properly containing, as an additive, an oxide, such as of lanthanum, calcium, strontium, molybdenum, tungsten, barium, niobium, zinc, nickel, manganese, cerium, cadmium, chrome, cobalt, antimony, iron, yttrium, tantalum, lithium, bismuth or tin, a combination of some of these, or other compounds. For example, it is also preferable that lead zirconate, lead titanate and lead magnesium niobate are used as a main component, and lanthanum or strontium is included therein for adjusting the coercive electric field or the piezoelectric characteristic.

On the other hand, it is preferable that the electrode of the piezoelectric element is made of a metal which is a solid in the room temperature and which has an excellent conductivity, for example, using a single metal such as aluminum, titanium, chrome, iron, cobalt, nickel, copper, zinc, niobium, molybdenum, ruthenium, palladium, rhodium, silver, tin, tantalum, tungsten, iridium, platinum, gold or lead, or an alloy comprising some of these, and further it is also possible to use a cermet material in which the same material as that of the piezoelectric film and/or the diaphragm is dispersed therein.

The selection of the material for the electrode of the piezoelectric element is determined depending upon the method of forming the piezoelectric film. For example, in a case in which a first electrode is formed on a diaphragm and a piezoelectric film is then formed on the first electrode by sintering, although there is a need to use, as the first electrode, a high melting point metal such as platinum which does not change at the sintering temperature of the piezoelectric film, since a second electrode to be formed on the piezoelectric film after the formation of the piezoelectric film permits the electrode formation at low temperatures, it is possible to use, as the second electrode, a low melting point metal such as aluminum.

In addition, the piezoelectric element can be made integrally at one time by the sintering, but in this case, there is a need to use, for both the first and second electrodes, a high melting point metal which can withstand the piezoelectric film sintering temperature. On the other hand, in the case of forming the first and second electrodes 91 and 92 on the piezoelectric film 90 like the piezoelectric element 94A shown in Fig. 3, it is possible to use the same low melting point metal for both. Thus, the first electrode and the second electrode can be selected properly in consideration of the piezoelectric film forming temperature represented by the piezoelectric film sintering temperature. Incidentally, the electrode leads can be formed simultaneously with the formation of the electrodes of the piezoelectric element, and the electrode leads on the diaphragm are formed simultaneously with the formation of the piezoelectric element and the electrode leads on the substrate can then be formed through the use of various methods such as the sputtering and screen printing.

Furthermore, while an insulating glass or resin is used as the material of the insulating layer to be formed on the piezoelectric element and the electrode leads, for preventing the deterioration of the displacement to enhance the performance of the device, it is preferable to use the resin rather than the glass. A proper resin is a fluorocarbon polymer (resin) showing an excellent chemical stability, for example, a terafluoroethylene based Teflon (Teflon PTFE produced by Du Pont K.K.), a terafluoroethylene-hexafluoropropylene copolymer based Teflon (Teflon FEP), a terafluoroethylene-perfluoroalkylvinylether copolymer based Teflon (Teflon PFA), a PTFE/PFA composite Teflon.

Furthermore, although being inferior in corrosion resistance, weather resistance and others to a fluorocarbon polymer, a silicone resin (particularly, a thermosetting silicone resin) is used as a suitable material. In addition, an epoxy resin, an acrylic resin or the like are available with the object. Still additionally, different materials are used for the piezoelectric element and the peripheral portion thereof and for the electrode lead and the peripheral portion thereof, respectively, to establish an insulating layer. Moreover, preferably, an inorganic/organic filler is added into the insulating resin for adjusting the rigidity of the diaphragm and other components.

In the case of the formation of the insulating layer, among desirable materials for the shield layer to be formed on the insulating layer, there are various kinds of metals, such as gold, silver, copper, nickel, aluminum and others. In addition, all the metallic materials for the aforesaid electrode in the piezoelectric element are also employable. Still additionally, an electrically conductive paste produced by mixing a metal powder with a resin is employable therefor.

Furthermore, a description will be given hereinbelow of a method of producing a device according to this invention, taking the forgoing device 39 for instance. Because of being constituted with a plurality of members including the connecting plate, the fixing plate and other components, for the production, the device according to this invention also accept joining the respective parts forming various members or materials prepared separately. However, in this case, the productivity does not become high and breakage easily occurs at the joints, which creates a problem in reliability. For this reason, this invention employs, as a suitable method, the green sheet laminating technique using a ceramic powder as the raw material.

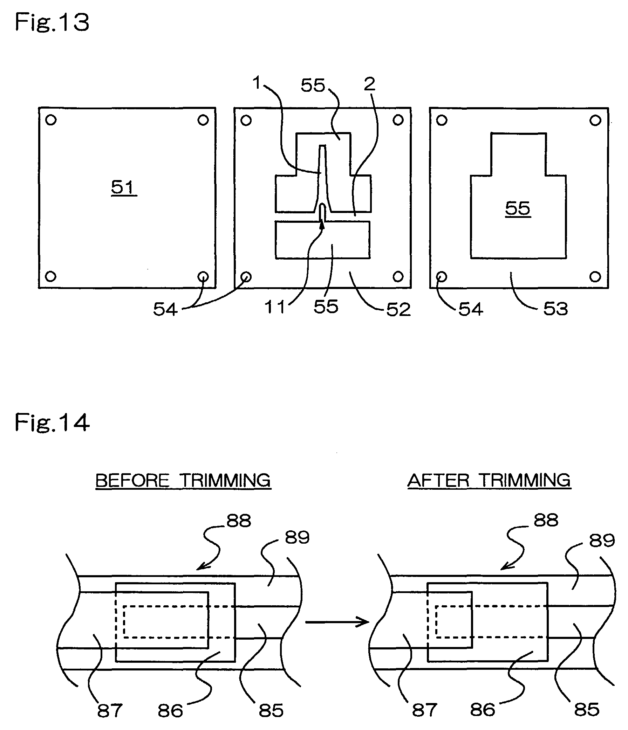

In the green sheet laminating technique, first, a binder, a solvent, a dispersant, and others are mixedly introduced into a ceramic power such as zirconia to produce a slurry. Subsequently, after the degassing of this slurry, a green sheet or a green tape, having a predetermined thickness, is produced according to a method such as the reverse-roll coater or the doctor blade. Following this, for example, by punching the green sheet through the use of a die, various green sheet members (which will be referred to hereinafter as sheet members) shown in Fig. 13 are produced.

A sheet member 51 to be formed into the substrate 5, the connecting plate 2, the fixing plate 1 and the diaphragms 3A to 3D after sintered is, at this point of time, in the form of one plate whose configuration is indefinite. This is because, as mentioned above, the diaphragms 3A to 3D is preferable to be as thin as 3 to 20 µm and, as compared with the formation of the configurations of these parts from the green sheet condition, from a viewpoint of the configurational accuracy, it is more preferable to cut off unnecessary portions therefrom by the laser beam machining.

A sheet member 52 which is for forming the substrate 5 and further for forming the fixing plate 1 and the connecting plate 2 so that they have a thickness larger than that of the diaphragms 3A to 3D, with the sheet member 52 being made to have a reference hole 54, window sections 55, the fixing plate 1 and the connecting plate 2. At the junction between the fixing plate 1 and the connecting plate 2, the formation of the notch portion 11 is possible. The desired thickness of the fixing plate 1 and the connecting plate 2 are obtainable by laminating a predetermined number of sheet members, more than one, each corresponding to this sheet member 52. Incidentally, in a case in which the fixing plate 1 is formed to have a thickness smaller than that of the connecting plate 2, only the fixing plate 1 portion is removed from the sheet member 52 and a plurality of sheet members each produced from the sheet member 52 by the removal are laminated. A sheet member 53 having a reference hole 54 and a window section 55 is for the formation of the substrate 5. A desired thickness thereof is achievable by laminating a predetermined number of sheets each corresponding to the sheet member 53.

These sheet members 51 to 53 are laminated in a state positioned through the use of the reference holes 54 in this order and then integrated with each other by the thermo compression bonding, thereby creating a laminated member. Thereafter, the laminated member is sintered at a temperature of 1200°C to 1600 °C. At this time, preferably, the piezoelectric elements 4A to 4D are formed in advance at the final positions of the formation of the diaphragms 3A to 3D in the sheet member 51 and are co-fired integrally with the laminated member.

For the location and formation of the piezoelectric elements 4A to 4D in the case of the co-firing of the laminated member and the piezoelectric elements, the piezoelectric films are formed according to the press formation method using a mold or the tape formation method using a slurry raw material and the piezoelectric films, before sintered, are laminated on the sheet member 51 by the thermo compression bonding and then sintered simultaneously to produce the substrate and the piezoelectric films concurrently. However, in this case, there is a need to form electrodes on the substrate or the piezoelectric films in advance through the use of the film formation method which will be described later.

The sintering temperature for the piezoelectric films is determined properly according to the material thereof, while it is commonly 800°C to 1400°C, preferably 1000°C to 1400°C. In this case, for controlling the composition of the piezoelectric film, it is preferable that, at the sintering, the atmosphere is adjusted to the existence of an evaporation source of the material of the piezoelectric film. In addition, particularly, in the case of using the substrate after sintering which will be described later, it is preferable that the aforesaid atmosphere adjustment for relieving the sintering stress in the piezoelectric film to exhibit a higher material characteristic is controlled by observing the piezoelectric film after the sintering for monitoring the distribution of the components.

For example, in the case of using a material containing lead zirconate like the material containing, as a main component, a component comprising lead zirconate, lead titanate and lead magnesium niobate, which is a piezoelectric ceramics forming a suitable material to be used in this invention, at the sintering, preferably, the atmosphere adjustment is made so that the zirconium is segregated in the sintered piezoelectric film. More preferably, the atmosphere is made so that the segregation of the zirconium component appears in the vicinity of the surface of while that segregation hardly occurs in the interior of the piezoelectric film. As compared with a piezoelectric film having no segregation, the piezoelectric film having such a component distribution is superior in vibration characteristic, that is, shows a large vibration amplitude, besides the material characteristic the piezoelectric powder has originally is maintainable without lowering largely because the sintering stress is relieved by the segregation of the zirconium component.

Accordingly, in the device according to this invention, most preferably, the piezoelectric element is made to have such a piezoelectric film. In addition to the production of the aforesaid piezoelectric film composition, it is preferable that, after the piezoelectric film sintering, the atmosphere of sintering is conducted so that the component of the piezoelectric material, particularly titanium oxide in the case of the piezoelectric material containing the titanium oxide, is contained in the parts of the device, such as the connecting plate and the substrate. Furthermore, in the case in which the sintering of the piezoelectric film and the sintering of the substrate are performed simultaneously, it is required that both the sintering conditions match with each other.

Moreover, the piezoelectric elements can be formed at the positions to be a diaphragm in the laminated member after sintering through the use of thick-film formation methods, such as screen printing, dipping, coating, electrophoresis, and various thin-film formation methods, such as ion beam, sputtering, vacuum deposition, ion plating, chemical vapor deposition (CVD) and plating. Of these, for the formation of the piezoelectric films, desirably, this invention employs the screen printing method, dipping method, coating method and the electrophoresis method. This is because these methods allow the formation of the piezoelectric films using a paste, slurry, suspension, emulsion, sol and others whose main component is piezoelectric ceramic particles or powder having an average particle size of 0.01 to 5 µm, preferably 0.05 to 3 µm to provide excellent piezoelectric operation characteristics. In addition, the electrophoresis method enables the formation of the film at a high density and at a high configurational accuracy and further mentions the feature stated in the technical document "DENKI KAGAKU", 53, No. 1 (1985) P63-68, written by Kazuo Anzai. Thus, the selection of the methods may be made properly in consideration of required accuracy, reliability and others.

For example, after a laminated member produced is sintered under a predetermined condition, a first electrode is printed and sintered at a predetermined position on a surface of the sheet member 51 sintered and a piezoelectric film is printed and sintered and further a second electrode is printed and fired, thereby providing the piezoelectric element. Subsequently, electrode leads for connecting the electrodes of the formed piezoelectric element to a measuring device are printed and fired. At this time, for example, if platinum (Pt) is used as the first electrode, lead zirconate titanate (PZT) is used as the piezoelectric film, gold (Au) is used as the second electrode and silver (Ag) is used as the electrode leads, since the sintering or firing temperature is set to decrease sequentially in the firing process, at one firing stage, re-sintering of the material fired before does not occur, thus preventing the occurrence of troubles such as peeling off or aggregation.

Incidentally, the selection of a proper material enables conducting sequential printing of the parts of the piezoelectric elements and the electrode leads thereof to achieve the integral firing at a time. Also, it is possible to form the electrodes and others at a low temperature after the formation of the piezoelectric films. Additionally, it is also acceptable to form the parts of the piezoelectric element and the electrode leads thereof through the use of a thin-film formation method such as the sputtering method or the deposition method. In this case, the heat treatment is not always necessary.

With the piezoelectric element being thus formed according to the film formation method, it is possible to integrally join and situate the piezoelectric elements and the diaphragms without using an adhesive, thereby securing the reliability and the reproducibility and facilitating the integration. In this case, it is possible that the piezoelectric film is shaped into an appropriate pattern, and as among the formation methods therefor, for example, there are screen printing, photolithography, laser beam machining, mechanical machining methods such as slicing or ultrasonic machining.

In this way, the diaphragms, the fixing plate and the notch portion, if needed, are made at predetermined positions of the sintered laminated member in which the piezoelectric elements and the electrode leads are provided. In this case, it is preferable to cut and remove unnecessary portions of the sintered sheet member 51 through the use of the machining using the fourth harmonic of the YAG laser. Thus, the device 39 comprising the diaphragms 3A to 3D, the fixing plate 1 and the connecting plate 2 having the configurations shown in Fig. 9 is obtainable. Incidentally, it is also possible that the portion corresponding to the substrate 5 and unnecessary portion is removed by the aforesaid laser beam machining or dicing.

In addition, it is preferable to adjust the configurations of the fixing plate 1 and the connecting plate 2 formed principally by the sheet member 52 or the configurations of the diaphragms 3A to 3D and others formed by the sheet member 51 at such machining for reducing the difference among the configurations, or to adjust the displacement quantity or the driving characteristic.

Still additionally, preferably, in the piezoelectric element 88 shown in Fig. 2, as shown in Fig. 14, the second electrode 87 is used as an upper electrode while the first electrode 85 is taken as a lower electrode and, after the piezoelectric element 88 having the piezoelectric film 86 is once placed between the upper electrode and the lower electrode, the upper electrode is mechanically trimmed by the fourth harmonic of the YAG laser to adjust the available electrode area of the piezoelectric element, thereby adjusting the electrical characteristics such as the impedance and others of the device to provide predetermined displacement characteristics. Incidentally, in a case in which the structure of the piezoelectric element 88 is a comb-like structure shown in Fig. 3 or 4, a portion of one of or both the electrodes may be trimmed.

As such machining, in addition to the aforesaid YAG fourth harmonic laser, the laser beam machining by the YAG laser, the second harmonic or third harmonic of the YAG laser, an eximer laser, a CO₂ laser or the like, and further electron beam machining, dicing (mechanical processing) or the like are employable to the size and shape of the device.

Furthermore, in addition to the manufacturing method using the aforesaid green sheets, the device according to this invention is producible by the use of a pressing method or the casting method using a molding an injection molding method, or the like. Also in this case, before or after the sintering, the machining is made by mechanical machining such as cutting, grinding, laser beam machining, punching, or ultrasonic machining, thereby accomplishing the formation into a predetermined configuration.

The insulating layer to be formed on the piezoelectric elements 4A to 4D and the electrode leads in the device 39 manufactured in this way is producible using a glass or a resin according to the screen printing method, the coating method, the spraying method, or the like. In the case in which the glass is used as the material, there is a need to increase the temperature of the device itself up to approximately the softening temperature of the glass, and since the hardness is high, there is a possibility of deteriorating the displacement or the vibration. On the other hand, the resin is soft, and the simple processing such as drying will do; therefore, the use of the resin is preferable.

Although, as described above, the resin to be used for the insulating layer is a fluorocarbon polymer or a silicone resin, in the case of using these resins, for the purpose of improving the adhesion with the ceramic substrate preferably, a primer layer is formed properly according to the kinds of the resin to be used and the ceramic, and the insulating layer is formed thereon.

Moreover, for the formation of the shield layer on the insulating layer, in the case of using the resin for the insulating layer, since the heat-treatment becomes difficult, if various metallic materials are put to use, a method such as a sputtering process which does not require heating is employed. On the other hand, in the case in which an electrically conductive paste comprising a metal powder and a resin is put to use, the screen printing, the coating or the like can be used as an appropriate manner. Incidentally, in the case of using a glass for the insulating layer, a conductor paste can be, for example, screen-printed and fired below a temperature which does not cause the flowage of the glass.

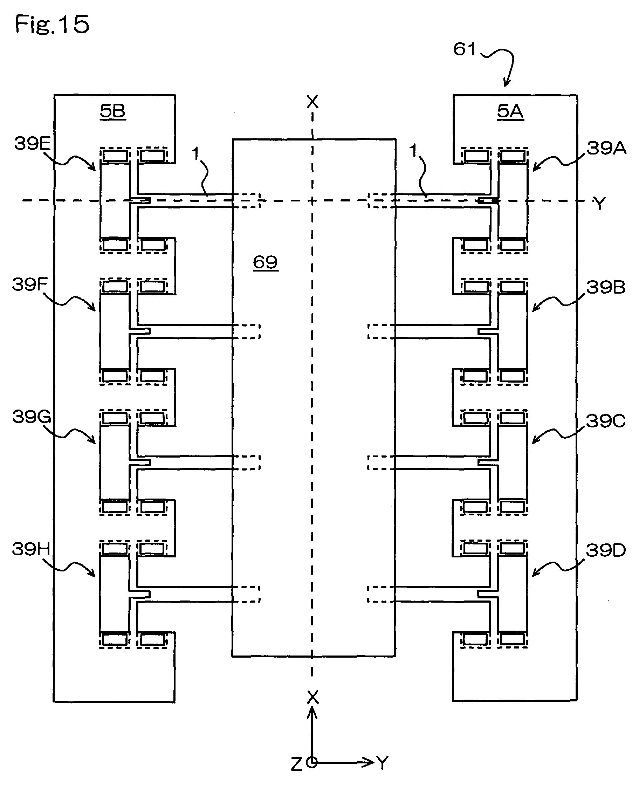

Although the embodiments, component material and manufacturing methods of the displacement control devices according to this invention have been described above, this invention further provides actuators using the foregoing various devices. In the structure of an actuator 61 shown in the plan view of Fig. 15, a plurality of (eight in total in the case of Fig. 15) devices 39 are provided such that the center lines (Y axes) of the fixing plates 1 are substantially parallel with each other and the X-Y planes of the fixing plates 1 are in the same plane in the stationary condition. In addition, an object 69 to be carried is placed to come into contact with the end portions of the respective fixing plates 1.

In the actuator 61, if the devices 39 located at the symmetrical positions with respect to the Z-X plane, for example the devices 39A and 39E, are driven so that the tip portions of the fixing plates 1 describe symmetrical hysteresis-like displacement loca with respect to the Z-X plane, a force of moving in the X-axis direction acts on the carried object 69. In this case, the direction of describing the hysteresis-like displacement locus is set depending upon which of the X-axis directions the carried object 69 is moved in. The devices 39B to 39D are driven to draw a hysteresis-like displacement locus similar to that of the device 39A while the devices 39F to 39H are drive to draw a hysteresis-like displacement locus similar to that of the device 39E, and the actuator 61 serves as a linear motor, a conveyer or the like.

The devices 39A to 39D are formed integrally on a substrate 5A while the devices 39E to 39H are formed integrally on a substrate 5B. An actuator having such a structure is easily producible through the use of the above-mentioned green sheet laminating method, while it is also possible that the devices 39A to 39H are manufactured separately and placed at predetermined position to thus constitute the actuator 61. Naturally, the devices constituting the actuator 61 are not limited to the device 39.

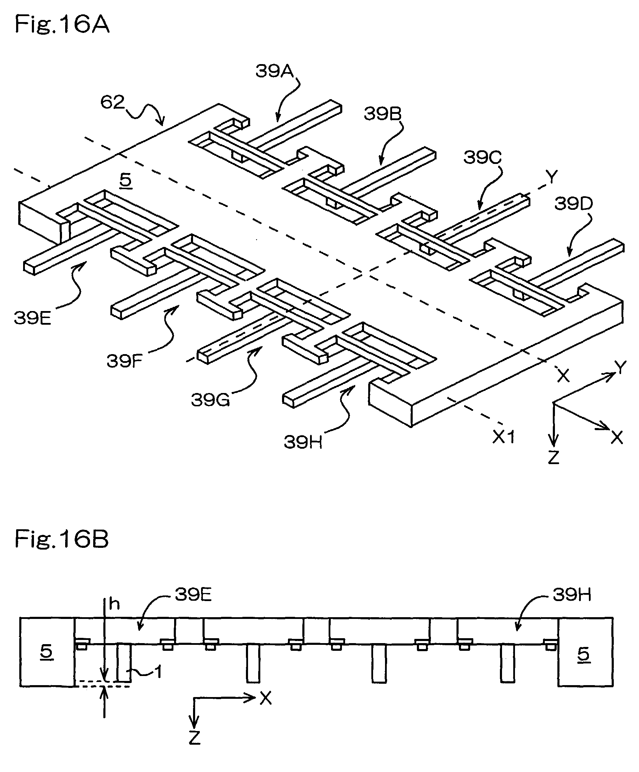

Figs. 16A and 16B show an actuator 62 in which eighth devices 39A to 39H are located to share one substrate 5 so that the tip portions of the fixing plates 1 are situated toward the outside of the substrate 5 and the center lines (Y axes) of the fixing plates 1 are in parallel relation to each other. Fig. 16A is a perspective view, while Fig. 16B is a cross-sectional view taken along X1 axis in the perspective view in a Z-X plane.

As well as the aforesaid actuator 61, when the devices 39A to 39H are driven, the actuator 62 can be used as a part which moves linearly by itself. As shown in Fig. 16B, when the actuator 62 is in the stationary condition, the substrate reaches the ground plane while the respective fixing plates 1 are in separated condition from the ground plane. When this difference h in height therebetween is set below the displacement quantity of the fixing plates 1 in the Z-axis direction, the height difference h functions as a clutch. That is, when the displacement quantity of the fixing plates 1 in the Z-axis direction exceeds the height difference h, the actuator 62 can be operative so that itself moves, and when the displacement quantity of the fixing plates 1 in the Z-axis direction is below the height difference h, the actuator 62 itself cannot move.

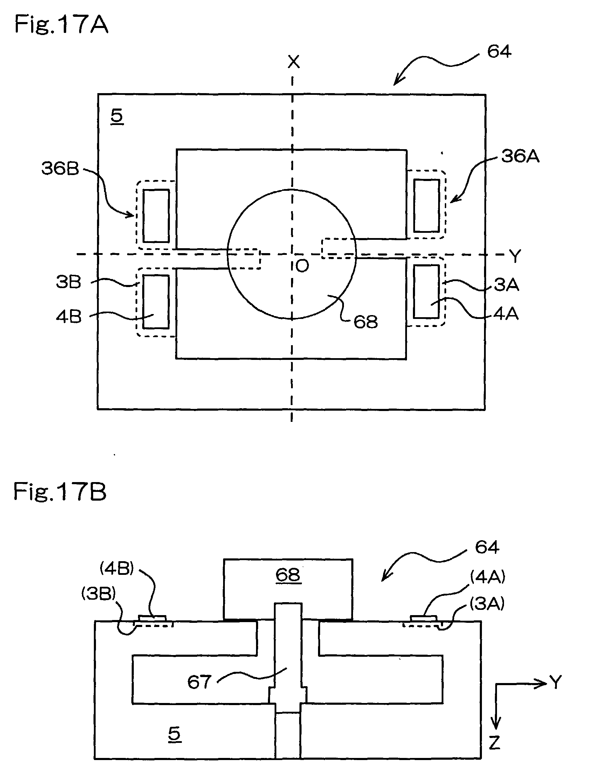

Fig. 17A is a plan view showing an actuator 64 using two devices 36 (devices 36A and 36B) shown in Fig. 1, and Fig. 17B is a cross-sectional view taken along the Y axis in Fig. 17A. In Fig. 17B, in order to make clear the positions of the diaphragms 3A and 3B and the piezoelectric elements 4A and 4B in the devices 36A and 36B, the positions of these parts which do not exist on the Y axis are shown additionally.

In Figs. 17A and 17B, the X axis and the Y axis are not set for each of the devices 36A and 36B, but an X-Y-Z orthogonal coordinate is set as illustrated and the intersection of these axes is set as the origin O. At this time, the actuator 64 has a structure in which the devices 36A and 36B are located at the positions organizing point symmetry with respect to the origin O. Additionally, a rotor 68 whose rotating center is determined by a shaft 67 is placed at the central portion of the actuator 64 to come into contact with each of the fixing plates 1 of the devices 36A and 36B. In this case, the rotating center of the shaft 67 coincides with the center of the point symmetry (the origin O) of the actuator 64.

When a predetermined signal (voltage) is applied to each of the devices 36A and 36B so that the connecting plate 2 of each of the devices 36A and 36B reciprocates between the P point and the R point shown in Fig. 5D, that is, takes the displacing motion in the Z-axis directions, the actuator serves as a motor for rotating the rotor 68 in a constant direction. At this time, the contact between the connecting plate 2 and the rotor 68 is made at a predetermined angle so that the rotation takes place in the constant direction. Additionally, in Figs. 17A and 17B, although the actuator is provided with a set of devices lying at the point symmetry positions, if another set of devices existing at the point symmetry positions are provided so that the contacting angle between the rotor 68 and the connecting plates 2 assumes positive and negative values in both the sets, the rotating movements thereof in two directions become preferably possible.

On the other hand, the devices 36A and 36B are driven so that the connecting plate 2 does not take the aforesaid Z-axis direction displacement mode but describes the rotating locus of P point → Q point → R point → S point → P point as shown in Figs. 5D, thereby setting up a rotational motion of the rotor 68. In this case, since the direct rotational motion of the connecting plate 2 can be transferred to the rotor 68, as compared with the case in which the rotation thereof takes place through the aforesaid Z-axis direction displacement, high-torque high-speed rotation becomes feasible, besides, owing to the change of the driving signal, only one set of devices preferably set up the rotation in both the directions.

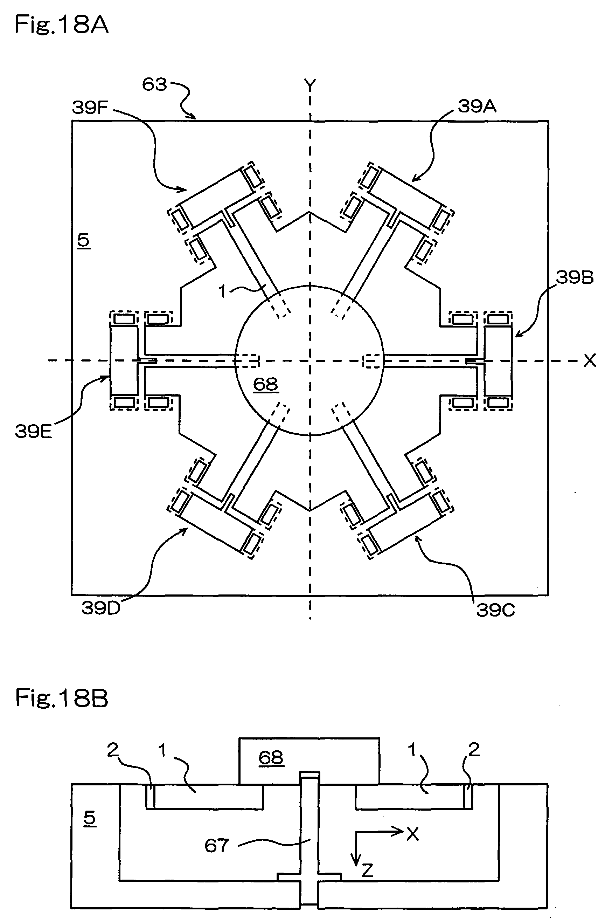

Fig. 18A is a plan view showing an actuator 63 in which the devices 39 are disposed circumferentially, and Fig. 18B is a cross-sectional view taken along the X axis in the plan view. In the actuator 63, the X axis and the Y axis are not set on each of devices 39A to 39F, but X, Y and Z axes are defined on the actuator 63 per se as shown in Fig. 18A.

In the actuator 63, the devices 39A to 39F are provided so that the center lines (lines indicative of the longitudinal directions) of the fixing plates 1 intersect with each other and the tip portions of the fixing plates 1 are directed to the intersection of the center lines (the intersection of the X axis and the Y axis). Additionally, a rotor 68 whose center of rotation is defined by a shaft 67 is placed at the central portion of the actuator 62 to come into contact with the fixing plates 1.

When all the devices 39A to 39F are driven so that a hysteresis takes place to cause a force from each of the fixing plates 1 to act in the direction of rotating the rotor 68 in one direction, it is possible to set up a rotating motion of the rotor 68. Additionally, in a manner that the direction the fixing plate 1 describes the hysteresis is reversed, the reverse of the rotating direction is easily possible and even at a high speed. Thus, the actuator 63 can be used properly as a motor.

Incidentally, as compared with the foregoing actuator 64, the actuator 63 can take more drive portions, thereby accomplishing a higher torque. Naturally, as well as the actuator 64, the driving of the rotor 68 by the displacement in the Z-axis directions is also possible.

Meanwhile, as well as the self-moved type actuator 62, if a disc-like substrate is put to use and the devices 39 are provided on the disc-like substrate so that the center lines of the fixing plates intersect with each other and, for example, the tip portions of the fixing plates protrude outwardly and radially from the disc-like substrate, then it is possible to provide a self-rotated type actuator. In this case, preferably, a shaft is provided on the disc-like substrate to define the center of rotation. In view of a method of applying a voltage to the piezoelectric elements, it is difficult to use such a self-rotated actuator as a rotating motor. However, it is sufficiently employable as an actuator for controlling microscopic angular displacement.

The actuators according to this invention can easily select their operating speed by controlling the frequency and voltage value of a voltage to be applied to the piezoelectric elements, and also exhibit a superior characteristic in operational performance including inaction and reverse.

While the embodiments of the displacement control devices and the actuators using these displacement control devices according to this invention have been described above in detail, it should be understood that this invention is not limited to these embodiments, and that it is intended to cover all changes and modifications of the embodiments of the invention by those skilled in the art, which do not constitute departures from the spirit and scope of the invention.

Each of the displacement control devices according to this invention is characterized in that its structure is simple, the size and weight reduction is easy, a high displacement efficiency is obtainable at saved power and it is independent of the harmful vibrations or the like from the external. Accordingly, it is possible to use the displacement control device itself as a sensor or an actuator. Additionally, an actuator comprising a plurality of displacement control devices can be used as a linear motor, a rotating motor, a position control actuator and others which are excellent in braking characteristic. Still additionally, because of using the green sheet laminating method which is a simple and easy manufacturing method which takes a wide design tolerance, the reliability is improvable by the employment of the integrated structure while the production is possible at a low cost. Moreover, the tolerance on the selection of the component materials is wide and suitable materials can be used according to the object on all such occasions.

The invention in other aspects also consists in the methods of making piezoelectric/electrostrictive devices herein described.

## Claims

1. A displacement control device comprising:
a substrate;
two diaphragms joined to at least side surfaces of a recess section made in the substrate; and
a connecting plate sandwiched between said two diaphragms and joined to a bottom surface of the recess section, so that at least one end portion of each of the two diaphragms joined to the connecting plate and an opposite end portion thereof joined to the substrate,
wherein at least two piezoelectric/electrostrictive elements independent of each other are located at both said diaphragms in a state distributed thereto, and said connecting plate is driven to describe a hysteresis-like displacement locus.

2. A displacement control device according to claim 1, wherein a fixing plate is joined to one end portion of said connecting plate.

3. A displacement control device comprising:
a substrate;
two diaphragms joined to at least side surfaces of recess sections made in the substrate, said recess sections being in opposed relation to each other;
a connecting plate whose one end portion in a lengthwise direction, sandwiched between at least said two diaphragms, and whose other end portion in the lengthwise direction being sandwiched between at least two different diaphragms, the connecting plate being placed to span between bottom surfaces of said recess sections , so that at least one end portion of each of said four diaphragms joined to the connecting plate and an opposite end portion thereof joined to the substrate; and
a fixing plate, a lengthwise direction of the fixing plate being in parallel with a direction in which said connecting plate is sandwiched between said diaphragms,
wherein at least two piezoelectric/electrostrictive elements independent of each other are located at least said two diaphragms which exist at said one end portion of the connecting plate and between which said connecting plate is sandwiched, and said fixing plate is driven to describe a hysteresis-like displacement locus.

4. A displacement control device according to claim 3, wherein a notch portion is made in a joined portion between said fixing plate and said connecting plate.

5. A displacement control device according to claim 3 or 4, wherein said connecting plate is divided into at least two sections in said lengthwise direction of said fixing plate and said fixing plate is joined to said at-least-two connecting plate sections.

6. A displacement control device according to claim 4 or 5, wherein a hinge section is set on said fixing plate to extend along said lengthwise direction of said fixing plate from said junction between said fixing plate and said connecting plate.

7. A displacement control device according to any one of claims 1 to 6, wherein, at least, said connecting plate and said diaphragms are joined to each other at their side surfaces.

8. A displacement control device according to any one of claims 1 to 7, wherein, at least, said connecting plate, said diaphragms and said substrate are formed integrally with each other.

9. A displacement control device according to any one of claims 1 to 8, wherein, at least, said connecting plate, said diaphragms and said substrate are produced through the use of a green sheet laminating technique.

10. A displacement control device according to any one of claims 1 to 9, wherein, in addition to said piezoelectric/electrostrictive elements for driving, one or more piezoelectric/electrostrictive elements are put to use as auxiliary elements.

11. A displacement control device according to any one of claims 1 to 10, wherein said piezoelectric/electrostrictive elements and electrode leads conducting to electrodes of said piezoelectric/electrostrictive elements are coated with an insulating layer made of one of a resin or a glass.

12. A displacement control device according to claim 11, wherein said resin is one of a fluorocarbon polymer or a silicone resin.

13. A displacement control device according to claim 11 or 12, wherein a shield layer made of an electrically conductive material is formed on a surface of said insulating layer.

14. A displacement control device according to any one of claims 1 to 13, wherein, at least, said substrate, said connecting plate and said diaphragms are made of one of a fully stabilized zirconia and a partially stabilized zirconia.

15. A displacement control device according to any one of claims 1 to 14, wherein a configuration of any one of said fixing plate, said connecting plate and said diaphragms is trimmed by one of laser beam machining and mechanical machining for dimensional adjustment.

16. A displacement control device according to any one of claims 1 to 15, wherein electrodes in said piezoelectric elements are processed by laser beam machining or mechanical machining for adjustment of an available electrode area of said piezoelectric elements.

17. An actuator using a plurality of displacement control devices each driven through drive of two or more independent piezoelectric/electrostrictive elements so that one of a connecting plate of each of said plurality of displacement control devices and/or a fixing plate thereof describes a hysteresis-like displacement locus, wherein said fixing plates are disposed so that their center lines run substantially parallel with each other and/or said connecting plates are disposed so that their center lines run parallel with each other.

18. An actuator using a plurality of displacement control devices each driven through the drive of two or more independent piezoelectric/electrostrictive elements so that one of a connecting plate of each of said plurality of displacement control devices and/or a fixing plate thereof describes a hysteresis-like displacement locus, said displacement control devices being located circumferentially.

19. An actuator according to claim 18, wherein said plurality of displacement control devices are disposed so that center lines of said fixing plates or said connecting plates intersect with each other and tip portions of said fixing plates or said connecting plates are directed to the intersection of said center lines of said fixing plates or said connecting plates.
